(19) Europäisches Patentamt
European Patent Office
Office européen des brevets

(11) EP 1 912 371 A2

(12) EUROPEAN PATENT APPLICATION

(43) Date of publication:
16.04.2008 Bulletin 2008/16

(51) Int Cl.:
H04L 1/06 (2006.01)    H04B 7/04 (2006.01)

(21) Application number: 07251610.7

(22) Date of filing: 17.04.2007

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(30) Priority: 10.10.2006 GB 0620072

(71) Applicant: KABUSHIKI KAISHA TOSHIBA
Tokyo 105-8001 (JP)

(72) Inventors:
• McNamara, Darren Phillip
  Bristol BS1 4ND (GB)
• Sandell, Magnus Stig Torsten
  Bristol BS1 4ND (GB)
• Lillie, Andrew George
  Bristol BS1 4ND (GB)

(74) Representative: Round, Edward Mark
Marks & Clerk
90 Long Acre
London WC2E 9RA (GB)

(54) Wireless communications apparatus

(57) In a lattice-reduction-aided receiver based wireless communications system, soft estimates of transmitted bit values are determined from a received signal by applying lattice reduction to the channel estimate and equalising the received signal in accordance with the reduced basis channel, and determining probabilities of transmitted bits having particular values. The method includes selecting an initial candidate vector in the reduced basis and determining further candidate vectors in the reduced basis dependently of the initial candidate vector, determining a corresponding transmitted symbol vector for each candidate vector and, on the basis of the received signal determining the probability of each transmitted bit value having been transmitted and log-likelihood ratios of transmitted bits. Determination of the log-likelihood ratio includes determining a first Euclidean distance corresponding to the initial symbol vector and a modified channel state matrix corresponding to the wireless communication system and then iteratively using the determined information to determine further Euclidean distances of further symbol vectors.

Fig. 3

**Description**

The present invention is in the field of wireless communication, and particularly, but not exclusively, the field of multiple input, multiple output (MIMO) communications systems.

Conventional communication systems can be represented mathematically as:

$$\mathbf{y} = \mathbf{H}\mathbf{x} + \mathbf{v}$$

in which, for a MIMO communication system, $\mathbf{y}$ is an $n$-by-1 vector representing the received signal, $\mathbf{H}$ is an n-by-m channel matrix modelling the transmission characteristics of the communications channel, $\mathbf{x}$ is an $m$-by-1 vector representing transmit symbols, v is an $n$-by-1 noise vector and wherein m and n denote the number of transmit and receive antennas respectively.

It will be understood by the skilled reader that the same representation can be used for multi-user detection in CDMA systems.

Recent publications have demonstrated how the use of a technique called Lattice Reduction can improve the performance of MIMO detection methods.

For example, "Lattice-Reduction-Aided Detectors for MIMO Communication Systems", (H. Yao and G.W. Womell, Proc. IEEE Globecom, Nov 2002, pp. 424-428) describes Lattice-reduction (LR) techniques for enhancing the performance of multiple-input multiple-output (MIMO) digital communication systems.

In addition, "Low-Complexity Near-Maximum-Likelihood Detection and Precoding for MIMO Systems using Lattice Reduction", (C. Windpassinger and R. Fischer, in Proc. IEEE Information Theory Workshop, Paris, March, 2003, pp. 346-348) studies the lattice-reduction-aided detection scheme proposed by Yao and Wornell. It extends this with the use of the well-known LLL algorithm, which enables the application to MIMO systems with arbitrary numbers of dimensions.

"Lattice-Reduction-Aided Receivers for MIMO-OFDM in Spatial Multiplexing Systems", (I. Berenguer, J. Adeane, I. Wassell and X. Wang, in Proc. Int. Symp. on Personal Indoor and Mobile Radio Communications, Sept. 2004, pp. 1517-1521, hereinafter referred to as "Berenguer et al.") describes the use of Orthogonal Frequency Division Multiplexing (OFDM) to significantly reduce receiver complexity in wireless systems with Multipath propagation, and notes its proposed use in wireless broadband multi-antenna (MIMO) systems.

Finally, "MMSE-Based Lattice-Reduction for Near-ML Detection of MIMO Systems", (D. Wubben, R. Bohnke, V. Kuhn and K. Kammeyer, in Proc. ITG Workshop on Smart Antennas, 2004, hereinafter referred to as "Wubben et al.") adopts the lattice-reduction aided schemes described above to the MMSE criterion.

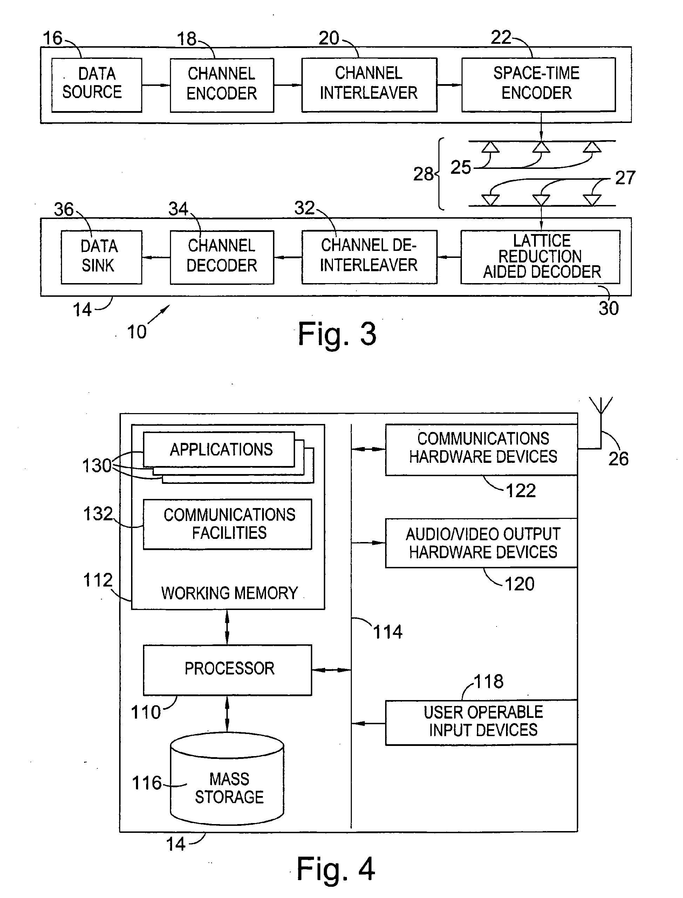

The techniques used in the publications described above use the concept that mathematically, the columns of the channel matrix, $\mathbf{H}$, can be viewed as describing the basis of a lattice. An equivalent description of this lattice (a so-called 'reduced basis') can therefore be calculated so that the basis vectors are close to orthogonal. If the receiver then uses this reduced basis to equalise the channel, noise enhancement can be kept to a minimum and detection performance will improve (such as, as illustrated in Figure 4 in Wubben et al.). This process comprises the steps described as follows:

$\mathbf{y}_r$, $\mathbf{x}_r$ and $\mathbf{H}_r$ are defined to be the real-valued representations of y, x, and H respectively, such that:

$$\mathbf{y}_r = \begin{bmatrix} \mathrm{Re}(\mathbf{y}) \\ \mathrm{Im}(\mathbf{y}) \end{bmatrix}, \qquad \mathbf{x}_r = \begin{bmatrix} \mathrm{Re}(\mathbf{x}) \\ \mathrm{Im}(\mathbf{x}) \end{bmatrix}, \qquad \mathbf{H}_r = \begin{bmatrix} \mathrm{Re}(\mathbf{H}) & -\mathrm{Im}(\mathbf{H}) \\ \mathrm{Im}(\mathbf{H}) & \mathrm{Re}(\mathbf{H}) \end{bmatrix}$$

where Re() and Im() denote the real and imaginary components of their arguments.

It will be noted that Berenguer et al. describes the equivalent method in the complex plane, though for the purpose of clarity the Real axis representation of the method is used herein.

A number of lattice reduction algorithms exist in the art. One suitable lattice reduction algorithm is the Lenstra-Lenstra-Lovasz (LLL) algorithm referred to above, which is disclosed in Wubben et al., and also in "Factoring Polynomials with Rational Coefficients", (A. Lenstra, H. Lenstra and L. Lovasz, Math Ann., Vol. 261, pp. 515-534, 1982, hereinafter referred to as "Lenstra et al."), and in "An Algorithmic Theory of Numbers, Graphs and Convexity", (L. Lovasz, Philadelpia, SIAM, 1980, hereinafter referred to as "Lovasz").

Any one of these can be used to calculate a transformation matrix, $\mathbf{T}$, such that a reduced basis, $\tilde{\mathbf{H}}_r$, is given by

$$\tilde{\mathbf{H}}_r = \mathbf{H}_r \mathbf{T}$$

The matrix T contains only integer entries and its determinant is +/-1.

After lattice reduction, the system is re-expressed as:

$$\begin{aligned}
\mathbf{y}_r &= \mathbf{H}_r \mathbf{x}_r + \mathbf{v}_r \\
&= \mathbf{H}_r \mathbf{T} \mathbf{T}^{-1} \mathbf{x}_r + \mathbf{v}_r \\
&= \tilde{\mathbf{H}}_r \mathbf{T}^{-1} \mathbf{x}_r + \mathbf{v}_r \\
&= \tilde{\mathbf{H}}_r \mathbf{z}_r + \mathbf{v}_r
\end{aligned}$$

where $\mathbf{z}_r = \mathbf{T}^{-1}\mathbf{x}_r$. The received signal, $\mathbf{y}_r$, in this redefined system is then equalised to obtain an estimate of $\mathbf{z}_r$. This equalisation process then employs, for example, a linear ZF technique, which obtains:

$$\tilde{\mathbf{z}}_r = (\tilde{\mathbf{H}}_r^* \tilde{\mathbf{H}}_r)^{-1} \tilde{\mathbf{H}}_r^* \mathbf{y}_r$$

Since $\tilde{\mathbf{H}}_r$ is close to orthogonal, $\tilde{\mathbf{z}}_r$ should suffer much less noise enhancement than if the receiver directly equalised the channel $\mathbf{H}_r$.

Of course, other equalisation techniques could be used. For example, MMSE techniques, or more complex successive interference cancellation based methods, such as in the published prior art identified above, could be considered for use.

A receiver in accordance with the above operates in the knowledge that the transmitted symbols contained in x are obtained from an M-QAM constellation. With this constraint, $\mathbf{x}_r$ can be formed as:

$$\mathbf{x}_r = \alpha s + \beta$$

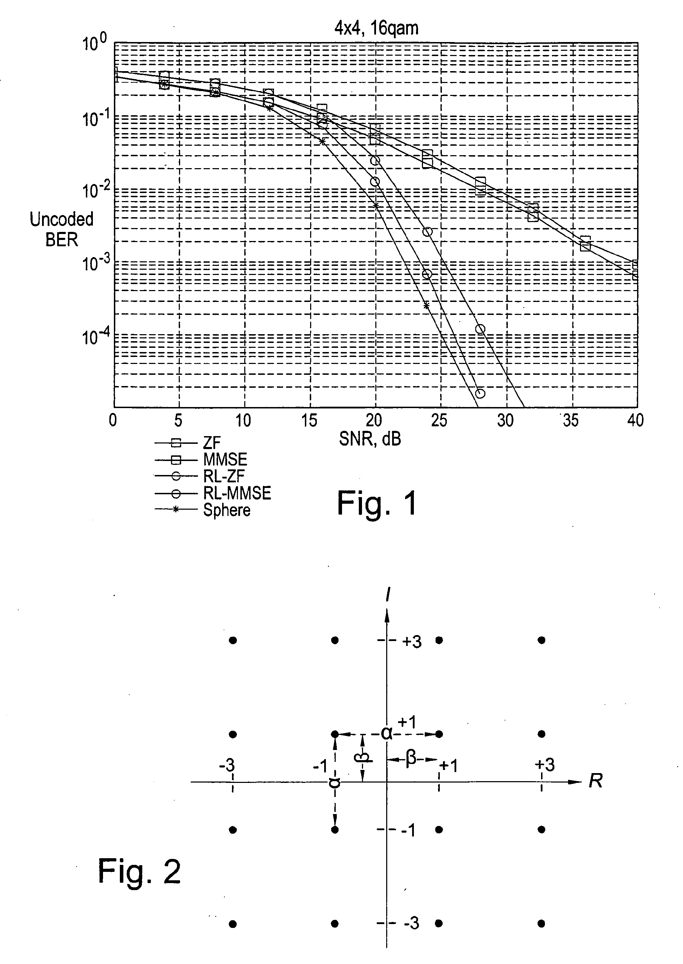

where $s$ is taken from the set of integers (limited by the dimension of the constellation) and $\alpha$ and $\beta$ are scalar values. The scalar values $\alpha$ and $\beta$ are obtained from the definition of the M-QAM constellation in use, as shown in figure 2; $\alpha$ is equal to the minimum distance between two adjacent constellation points, while $\beta$ is the offset from the origin when $s=0$. In the present example, a 16-QAM constellation is used, having real and imaginary components of {+/-1, +/-3}. Therefore, as shown in figure 2, $\alpha=2$ and $\beta=1$.

Subsequently, the equalised signal, $\tilde{\mathbf{z}}_r$, can be quantised as $\hat{\mathbf{z}}_r$, wherein:

$$\hat{\mathbf{z}}_r = \alpha Q\left\{ \frac{1}{\alpha}\left( \tilde{\mathbf{z}}_r - \mathbf{T}^{-1}\mathbf{1}\beta \right) \right\} + \mathbf{T}^{-1}\mathbf{1}\beta$$

where Q{} is a quantisation function, which rounds each element of its argument to the nearest integer, and where 1 is a column vector of ones.

It will be understood from the above that, the quantisation function apart, the remaining operations are a result of M-QAM constellations being scaled and translated versions of the integer lattice. The integer quantisation therefore requires the same simple scaling and translation operations.

Finally, the estimate $\hat{\mathbf{x}}_r$ of $\mathbf{x}_r$ is obtained by this method as

$$\hat{\mathbf{x}}_r = \mathbf{T}\hat{\mathbf{z}}_r$$

Occasionally, if errors are present in the estimate of $\hat{\mathbf{z}}_r$, then it is possible that some of the symbol estimates in $\hat{\mathbf{x}}_r$ may not be valid symbols. In such cases, these symbols are mapped to the nearest valid symbol. For example, for the present example employing 16-QAM, the values +/-1, +/-3 may define the valid entries in $\hat{\mathbf{x}}_r$. Therefore if a component of $\hat{\mathbf{x}}_r$ were, for example, equal to +5, then this would be mapped to a value of +3.

Figure 1 demonstrates the relative performance of techniques in accordance with the published art, including the above described example thereof, over other MIMO detection methods for an uncoded system. 'ZF' and 'MMSE' refer to the standard linear detection methods, 'RL-ZF' and 'RL-MMSE' refer to the lattice reduction aided methods, and 'Sphere' refers to results obtained using the Sphere decoding algorithm (almost identical to the performance of maximum-likelihood detection).

Such reduced lattice detectors (e.g. for MIMO systems) usually output hard decisions. The only mention in the literature of a technique that could be employed for obtaining soft-output is "From Lattice-Reduction-Aided Detection Towards Maximum-Likelihood Detection in MIMO Systems", (C. Windpassinger, L. Lampe and R. Fischer, in Proc. Int. Conf. on Wireless and Optical Communications, Banff, Canada, July 2003, hereinafter referred to as "Windpassinger et al."). The method that Windpassinger et al. proposes is complex, and the performance of this technique was not validated in the publication. Therefore it is an aim of aspects of the present invention to provide a MIMO detector capable of determining a soft output using a simple and proven approach.

US Patent 6724843 describes a detector in which received symbols are decoded in a multiple-antenna communication system using lattice-based decoding. The symbols are generated using a modulation constellation, e.g., a diagonal modulation constellation, and the constellation is characterized as a lattice for decoding purposes. For example, if a given communication link of the multiple-antenna communication system includes M transmitter antennas and a single receiver antenna, the diagonal modulation constellation can be characterized as a lattice in M dimensions. A differential decoding operation for received differential symbols involves a determination of the closest point in the lattice corresponding to the constellation. This determination may be made in an efficient manner using a basis reduction algorithm which generates an approximately orthogonal basis for the lattice, and then utilizes component-wise rounding to determine the closest point. The lattice-based decoding has a complexity which is polynomial rather than exponential in the particular number of antennas and the system rate, but is nonetheless able to deliver error rate performance which approximates that of maximum likelihood decoding.

Therefore, with the exception of Windpassinger et al., the reduced lattice detection schemes described in all other references only output hard decisions for the estimate of the transmitted symbol vector, $\hat{\mathbf{x}}$. When used in a system with an outer channel code (i.e. in any practical system) the performance of the code can be substantially improved if it is supplied with soft-information, e.g. a log-likelihood ratio (LLR) for each bit.

Since the complexity of the LLR evaluation grows superlinearly with the number of transmit antennas, for a wireless communication system utilising a large number of antennas it is desirable to reduce computational complexity.

Aspects of the invention are provided in accordance with the subject matter of the appended claims.

The method in accordance with the invention is suitable for use in a MIMO wireless communications system. Further, it can be used with any other system wherein a received signal is the result of transmission from a plurality of antennas, which may or may not be collocated. Further, the method is applicable to CDMA systems, such as multi-user detection (MUD).

To this end, the probabilities determined in either the method according to the invention or by the detector according to the invention can be converted into LLRs.

In addition to the above aspects, aspects of the invention can be delivered in the form of processor executable instructions for configuring a general purpose, communications compatible computer. Such instructions may be provided in software form, such as a carrier, a storage medium or a signal. Also, the instructions may be provided on a solid state memory means, such as flash memory, or by means of an ASIC or other preconfigured processing means.

Figure 1 illustrates a graph of performance of prior art examples described above in comparison with standard MIMO detection methods for an uncoded system;

Figure 2 illustrates a graph of a lattice used in the wireless communications system of a specific embodiment of the invention, and used in the described examples of the prior art;

Figure 3 illustrates schematically a MIMO system including a transmitter and a receiver;

Figure 4 illustrates in further detail the receiver of figure 3;

Figure 5 illustrates a detecting method operable by means of the detector illustrated in figure 4;

Figure 6 illustrates a routine for implementing a step of determining log likelihood ratios of the detecting method illustrated in figure 6;

Figure 7 illustrates a graph of performance of prior art examples described above in comparison with standard MIMO detection methods for a coded system.

The present invention will now be described with reference to a specific embodiment thereof for the equalization of a wireless communication system. Figure 3 illustrates such a system, comprising a MIMO data communications system 10 of generally known construction.

The communications system 10 comprises a transmitter device 12 and a receiver device 14. It will be appreciated that in many circumstances, a wireless communications device will be provided with the facilities of a transmitter and a receiver in combination but, for this example, the devices have been illustrated as one way communications devices for reasons of simplicity.

The transmitter device 12 comprises a data source 16, which provides data (comprising information bits or symbols) to a channel encoder 18. The channel encoder 18 is followed by a channel interleaver 20 and, in the illustrated example, a space-time encoder 22. The space-time encoder 22 encodes an incoming symbol or symbols as a plurality of code symbols for simultaneous transmission from a transmitter antenna array 24 comprising a plurality of transmit antennas 25. In this illustrated example, three transmit antennas 25 are provided, though practical implementations may include more, or fewer antennas depending on the application.

The encoded transmitted signals propagate through a MIMO channel 28 defined between the transmit antenna array 24 and a corresponding receive antenna array 26 of the receiver device 14. The receive antenna array 26 comprises a plurality of receive antennas 27 which provide a plurality of inputs to a lattice-reduction-aided decoder 30 of the receiver device 14. In this specific embodiment, the receive antenna array 26 comprises three receive antennas 27.

The lattice-reduction-aided decoder 30 has the task of removing the effect of the MIMO channel 28. The output of the lattice-reduction-aided decoder 30 comprises a plurality of signal streams, one for each transmit antenna 25, each carrying so-called soft or likelihood data on the probability of a transmitted bit having a particular value. This data is provided to a channel de-interleaver 32 which reverses the effect of the channel interleaver 20, and the de-interleaved bits output by this channel de-interleaver 32 are then presented to a channel decoder 34, in this example a Viterbi decoder, which decodes the convolutional code. The output of channel decoder 34 is provided to a data sink 36, for further processing of the data in any desired manner.

The specific function of the lattice-reduction-aided decoder 30 will be described in due course.

Figure 4 illustrates schematically hardware operably configured (by means of software or application specific hardware components) as the receiver device 16. The receiver device 16 comprises a processor 110 operable to execute machine code instructions stored in a working memory 112 and/or retrievable from a mass storage device 116. By means of a general purpose bus 114, user operable input devices 118 are capable of communication with the processor 110. The user operable input devices 118 comprise, in this example, a keyboard and a mouse though it will be appreciated that any other input devices could also or alternatively be provided, such as another type of pointing device, a writing tablet, speech recognition means, or any other means by which a user input action can be interpreted and converted into data signals.

Audio/video output hardware devices 120 are further connected to the general purpose bus 114, for the output of information to a user. Audio/video output hardware devices 120 can include a visual display unit, a speaker or any other device capable of presenting information to a user.

Communications hardware devices 122, connected to the general purpose bus 114, are connected to the antenna 26. In the illustrated embodiment in Figure 4, the working memory 112 stores user applications 130 which, when executed by the processor 110, cause the establishment of a user interface to enable communication of data to and from a user. The applications in this embodiment establish general purpose or specific computer implemented utilities that might habitually be used by a user.

Communications facilities 132 in accordance with the specific embodiment are also stored in the working memory 112, for establishing a communications protocol to enable data generated in the execution of one of the applications 130 to be processed and then passed to the communications hardware devices 122 for transmission and communication with another communications device. It will be understood that the software defining the applications 130 and the communications facilities 132 may be partly stored in the working memory 112 and the mass storage device 116, for convenience. A memory manager could optionally be provided to enable this to be managed effectively, to take account of the possible different speeds of access to data stored in the working memory 112 and the mass storage device 116.

On execution by the processor 110 of processor executable instructions corresponding with the communications facilities 132, the processor 110 is operable to establish communication with another device in accordance with a recognised communications protocol.

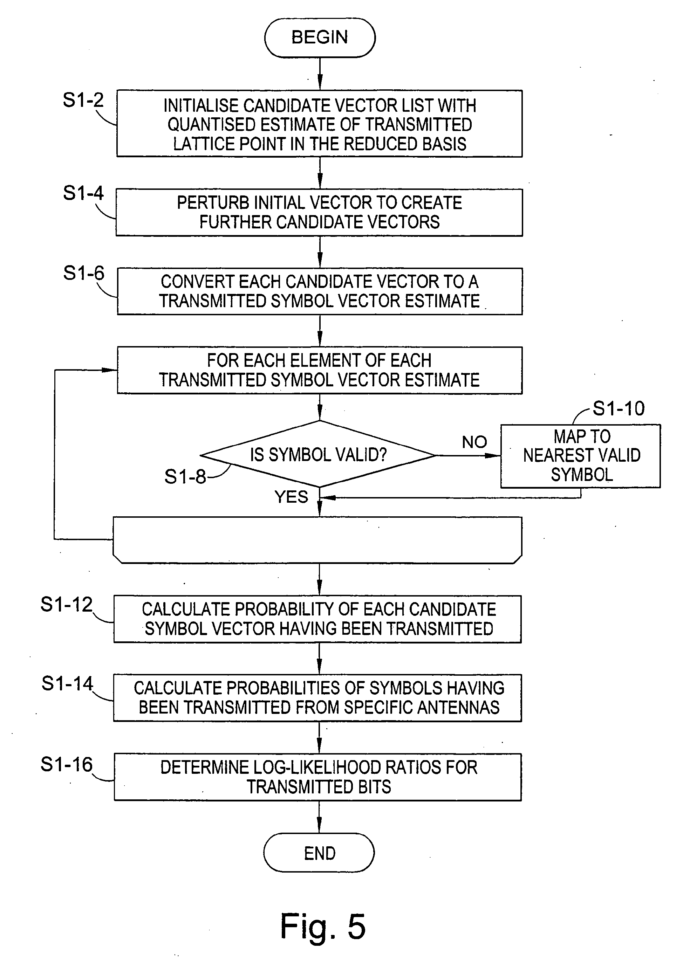

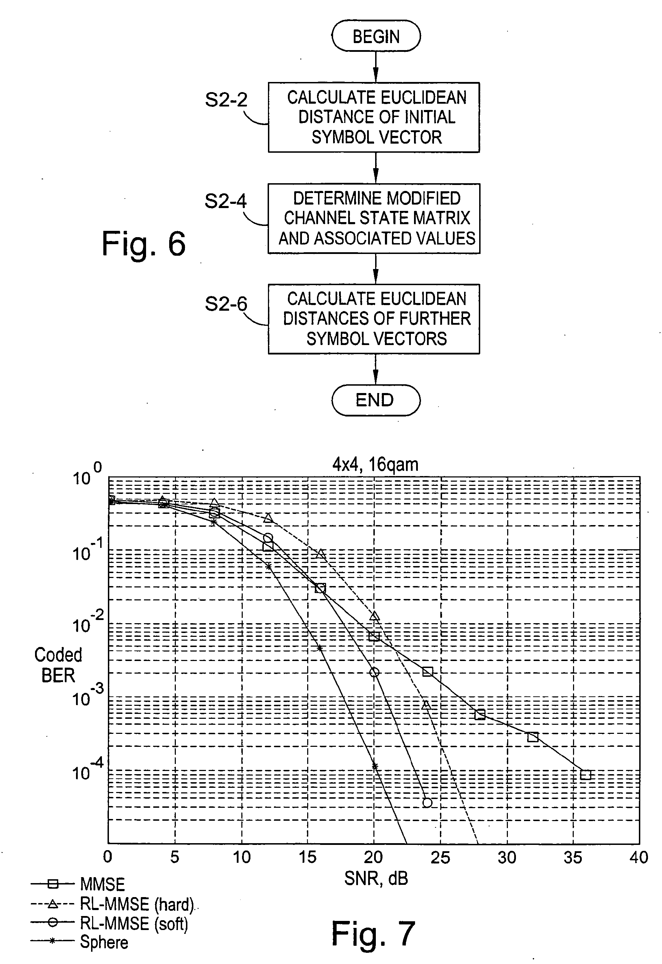

The function of the lattice-reduction aided decoder 30 will now be described in further detail in accordance with figure 5 and figure 6. This method as illustrated commences once the quantised estimate of the transmitted lattice point in the reduced basis, i.e. $\hat{\mathbf{z}}_r$, has been determined as outlined in the introduction and discussion of the prior art above. The manner in which this estimate is obtained is immaterial: any appropriate lattice reduction algorithm may have been used, and any of a number of equalisation methods may have been applied.

In step S1-2, the vector $\hat{\mathbf{z}}_r$ is taken as the first entry in a list of candidate vectors. Other candidate vectors are then obtained in step S1-4 by modifying one or more elements of the vector $\hat{\mathbf{z}}_r$ and adding these as new candidate vectors to the list.

Whilst typically any of these additional candidate vectors may differ from $\hat{\mathbf{z}}_r$ in more than one element, the present embodiment generates candidates by only ever allowing these to vary one element of $\hat{\mathbf{z}}_r$, for reasons of simplicity, both of the present description and of computation.

For the purpose of this description, the ith candidate vector in this list is defined as $\mathbf{c}^{(i)}$, and hence $\mathbf{c}^{(1)} = \hat{\mathbf{z}}_r$. In this description, $\mathbf{c}^{(1)}$ and $\mathbf{c}^{(i,i\neq1)}$ are additionally referred to as the 'initial' and 'further' candidate vectors, respectively.

For the purpose of this description of a specific embodiment, a particular method of generating a list of candidates is to perturb each element of $\hat{\mathbf{z}}_r$ in turn by $+/-\alpha$ (where $\alpha$ is the minimum distance between 2 constellation points, as defined above with reference to figure 2).

For example, if $\hat{\mathbf{z}}_r$ is a 2-by-1 vector, then there would be 4 further candidate vectors, giving a total of 5 candidates as follows:

$$\mathbf{c}^{(1)} = \begin{bmatrix} \hat{z}_{r1} \\ \hat{z}_{r2} \end{bmatrix}, \ \mathbf{c}^{(2)} = \begin{bmatrix} \hat{z}_{r1} + \alpha \\ \hat{z}_{r2} \end{bmatrix}, \ \mathbf{c}^{(3)} = \begin{bmatrix} \hat{z}_{r1} - \alpha \\ \hat{z}_{r2} \end{bmatrix},$$

$$\mathbf{c}^{(4)} = \begin{bmatrix} \hat{z}_{r1} \\ \hat{z}_{r2} + \alpha \end{bmatrix}, \qquad \mathbf{c}^{(5)} = \begin{bmatrix} \hat{z}_{r1} \\ \hat{z}_{r2} - \alpha \end{bmatrix}.$$

The effect of perturbing elements of $\hat{\mathbf{z}}_r$ is to generate other points in the reduced lattice. The perturbations by $+/- \alpha$ give the closest points in the lattice as the distance between any two neighbouring points. An implementation may alternatively choose to increase the list of candidates through perturbing elements of $\hat{\mathbf{z}}_r$ by multiples of $\alpha$ (i.e. to not just the closest point, but the closest few points).

Once a list of candidate vectors in the reduced lattice has been obtained then, in step S1-6, each candidate is converted to a transmitted symbol vector estimate. The list of transmitted symbol vector estimates is $\hat{\mathbf{x}}_r^{(i)}$, giving:

$$\mathbf{x}_r^{(i)} = \mathbf{T}\mathbf{c}^{(i)}$$

where T is the lattice reduction transformation matrix as defined above. In this description, the vectors $\hat{\mathbf{x}}_r^{(1)}$ and $\hat{\mathbf{x}}_r^{(i,i\neq1)}$ are additionally referred to as the 'initial' and 'further' transmitted symbol vectors and correspond to $\mathbf{c}^{(1)}$ and $\mathbf{c}^{(i, i\neq1)}$, respectively.

Just as for the hard-output detector outlined in the introduction and discussion of the prior art above, occasionally it is possible that some of the elements of the vector $\hat{\mathbf{x}}_r^{(i)}$ may not be valid symbols. Therefore, step S1-8 seeks to determine if this is the case, and, if so, in step S1-10, these symbols are mapped to the nearest valid symbol. For example, for 16-QAM, if the values +/-1, +/-3 define the valid entries as illustrated in figure 2, then if an element were, for example, equal to +5, this would be mapped to a value of +3.

For each candidate symbol vector $\hat{\mathbf{x}}_r^{(i)}$ (corrected, if required), in step S1-12, the detector calculates its probability of being transmitted as:

$$p^{(i)} = \frac{1}{\sqrt{\pi\sigma_v^2}} \exp\left( \frac{-\left\| \mathbf{y}_r - \mathbf{H}_r \hat{\mathbf{x}}_r^{(i)} \right\|}{\sigma_v^2} \right)$$

These probabilities are then used to calculate, in step S1-14, the probability of symbol *x'* having been transmitted from antenna k, where *x'* ∈ *X* and X defines the set of symbols in the chosen constellation.

$$P(k, x') = \sum_{\{i | \hat{x}_k^{(i)} = x'\}} p^{(i)} \qquad \text{for } k = 1, \ldots, m \quad \text{and} \quad x' \in X$$

Depending on the list of candidates, according to the above definition P may not be specified for all values of k and *x'*. In these cases P is set to a default (small) value. This default can be a fixed value or it could varied according to a method such as that described in "Adaptive Selection of Surviving Symbol Replica Candidates Based on Maximum Reliability in QRM-MLD for OFCDM MIMO Multiplexing" (K. Higuchi, H. Kawai, N. Maeda and M. Sawahashi, in Proc. IEEE Globecom, Dallas, Dec. 2004), or by any other appropriate method.

Now that the receiver has information on the probability of different symbols having been transmitted, these are processed in step S-16 to obtain a log-likelihood ratio (LLR) for each transmitted bit. In the present embodiment of the invention, this is done as follows:

$$L\left(b_{q,m}\right) = \log\left( \frac{\Pr\left(b_{q,m} = 1 | \mathbf{y}_r\right)}{\Pr\left(b_{q,m} = 0 | \mathbf{y}_r\right)} \right)$$

$$= \log\left( \frac{\sum_{x \in \chi_1^{(q,m)}} f\left(\mathbf{y}_r | \mathbf{x}_r\right)}{\sum_{x \in \chi_0^{(q,m)}} f\left(\mathbf{y}_r | \mathbf{x}_r\right)} \right)$$

$$\approx \frac{1}{2\sigma_v^2}\left( \min_{i \in \chi_0^{(q,m)}} \left\| \mathbf{y}_r - \mathbf{H}_r \hat{\mathbf{x}}_r^{(i)} \right\|^2 - \min_{i \in \chi_1^{(q,m)}} \left\| \mathbf{y}_r - \mathbf{H}_r \hat{\mathbf{x}}_r^{(i)} \right\|^2 \right)$$

where $L(b_{q,m})$ is the log-likelihood ratio of bit $b_{q,m}$ and $\chi_0^{(q,m)}$ (or $\chi_1^{(q,m)}$) indicates the set of transmitted symbol estimates, $\hat{\mathbf{x}}_r^{(i)}$, such that the $q^{th}$ bit of the $m^{th}$ symbol is 0 (or 1).

It will be understood that in the above given approximation, $\left\| y_r - H_r \hat{x}_r^{(i)} \right\|^2$ represents the Euclidean distance, $d^{(i)}$, in M-QAM constellation space, of transmitted symbol vector $\hat{\mathbf{x}}_r^{(i)}$.

It will be further understood that calculating the log-likelihood ratio for every transmitted bits requires calculation of the Euclidean distance, $d^{(i)}$, for each corresponding transmitted symbol vector $\hat{\mathbf{x}}_r^{(i)}$.

A detailed description of the step performed at step S1-16 will now be described with reference to figure 6.

In the present embodiment, symbol vector Euclidean distances are determined by first calculating, in step S2-2, the distance, $d^{(1)}$, for the initial symbol vector $\hat{\mathbf{x}}_r^{(1)}$ :

$$d^{(1)} = \left\| \mathbf{y}_r - \mathbf{H}_r \hat{\mathbf{x}}_r^{(1)} \right\|^2 .$$

A modified channel state matrix, ($\alpha$**HT**), and associated values, such as its column norms, are calculated in step S2-4. However, it is noted that these may be pre-computed for a given channel state, H, and stored in working memory 112 of the receiver in order to expedite the subsequent step and reduce its computational complexity.

Euclidean distances, $d^{(i, i \neq 1)}$, of further symbol vectors, $\hat{\mathbf{x}}_r^{(i, i \neq 1)}$, are then calculated in step S2-6 on the basis of the information determined in steps S2-2 and S2-4, as shown below:

$$
\begin{aligned}
d^{(i)} &= \left\| \mathbf{y}_r - \mathbf{H}_r \hat{\mathbf{x}}_r^{(i)} \right\|^2 \\
&= \left\| \mathbf{y}_r - \mathbf{H}_r \left( \hat{\mathbf{x}}_r^{(1)} \pm \alpha \mathbf{t}_k \right) \right\|^2 \\
&= \left\| \left( \mathbf{y}_r - \mathbf{H}_r \hat{\mathbf{x}}_r^{(1)} \right) \mp \alpha \mathbf{H}_r \mathbf{t}_k \right\|^2 \\
&= \left\| \mathbf{y}_r - \mathbf{H}_r \hat{\mathbf{x}}_r^{(1)} \right\|^2 + \left\| \left( \alpha \mathbf{H}_r \mathbf{T} \right)_k \right\|^2 \mp 2 \left( \mathbf{y}_r - \mathbf{H}_r \hat{\mathbf{x}}_r^{(1)} \right)^T \left( \alpha \mathbf{H}_r \mathbf{T} \right)_k \\
&= d^{(1)} + \left\| \left( \alpha \mathbf{H}_r \mathbf{T} \right)_k \right\|^2 \mp 2 \left( \mathbf{y}_r - \mathbf{H}_r \hat{\mathbf{x}}_r^{(1)} \right)^T \left( \alpha \mathbf{H}_r \mathbf{T} \right)_k
\end{aligned}
$$

where $\mathbf{t}_k$ is the $k^{th}$ column of **T**, and $(\alpha\mathbf{HT})_k$ is the $k^{th}$ column of ($\alpha$**HT**).

It will be appreciated that this implementation remains valid for cases where the list of candidates is chosen by perturbing elements of $\hat{\mathbf{z}}_r$ by multiples of $\alpha$, in which case the perturbations become +/- n $\alpha$, where n is a scalar value.

The graph of figure 7 sets out experimental performance data of a method performed in accordance with the present embodiment in comparison with prior art decoding methods aiming to provide hard information for the channel decoder. Figure 7 demonstrates the benefit that can be obtained by providing a lattice reduction detection scheme to output soft information for the channel decoder.

It will be appreciated that the foregoing disclosure of specific embodiments of the invention can be applied to any communications product employing MIMO transmission techniques, to take advantage of the benefits of the invention. Further, the invention is applicable to any circumstance in which the detection of symbols which may be based on multiple input is required. This could arise in systems where a plurality of antennas are provided in separate locations. Further, CDMA MUD may be a suitable basis for use of the method of the present invention.

The invention has been described by way of a software implementation. This software implementation can be introduced as a stand alone software product, such as borne on a storage medium, e.g. an optical disk, or by means of a signal. Further, the implementation could be by means of an upgrade or plug-in to existing software.

Whereas the invention can be so provided, it could also be by way exclusively by hardware, such as on an ASIC, a DSP board, a solid state memory means, such as flash memory, or the like.

The reader will appreciate that the foregoing is but one example of implementation of the present invention, and that further aspects, features, variations and advantages may arise from using the invention in different embodiments. The scope of protection is intended to be provided by the claims appended hereto, which are to be interpreted in the light of the description with reference to the drawings and not to be limited thereby.

**Claims**

1. A method for determining soft estimates of transmitted bit values from a received signal in a lattice-reduction-aided receiver based wireless communications system, the method comprising obtaining an estimate of the channel response, applying lattice reduction to said channel response and equalisation of said received signal in accordance with a reduced basis channel, and determining probabilities of transmitted bits having particular values by means of:

   determining an initial candidate vector in the reduced basis, and
   determining Log Likelihood Ratios (LLR) of each transmitted bit, said LLRs being based on Euclidian distances of candidate vectors from said channel response, wherein the step of determining LLRs includes:

determining a Euclidian distance between said initial candidate vector and said channel response,
determining a reduced basis matrix corresponding to a reduced basis description of the lattice wherein said reduced basis matrix comprises substantially orthogonal basis vectors,
determining column norms for said basis vectors and
determining distances for further determined candidate vectors, each distance being determined as a sum of said calculated distance for said initial candidate symbol vector,
a product of a selected one of the predetermined column norms
and an integer multiple of the minimum inter-candidate distance, and
either a positive or a negative multiple of 2 of a scalar product of
said selected predetermined column with a vector difference between the channel response vector and the initial candidate vector.

2. A method in accordance with claim 1 wherein said integer multiple of the minimum inter-candidate distance is a unit multiple of the minimum inter-candidate distance.

3. A method in accordance with claim 1 or claim 2 wherein the product of said column norms and an integer multiple of the minimum inter-candidate distance is predetermined by determining a product of said reduced basis matrix with said minimum inter-candidate distance as a preliminary step.

4. A method in accordance with any preceding claim wherein said candidate vector space defines an M-QAM symbol constellation.

5. A method in accordance with claim 4 wherein said symbol constellation is 16-QAM.

6. A method in accordance with any preceding claim and further including the step of mapping said list of candidate transmitted symbol vectors to permitted transmitted symbols.

7. A method in accordance with any preceding claim wherein the step of determining transmitted bit probabilities includes determining the probability of each candidate symbol vector having been transmitted and then determining the probabilities of all possible symbols having been transmitted from each of said transmitter antennas.

8. A method of detecting information borne on a MIMO communications channel, comprising the method of any preceding claim.

9. Apparatus for determining soft estimates of transmitted bit values from a received signal in a lattice-reduction-aided receiver based wireless communications system, the apparatus comprising means for obtaining an estimate of the channel response, means for applying lattice reduction to said channel response and equalisation of said received signal in accordance with a reduced basis channel, and means for determining probabilities of transmitted bits having particular values, said means for determining probabilities comprising:

means for determining an initial candidate vector in the reduced basis, and
means for determining Log Likelihood Ratios (LLR) of each transmitted bit, said LLRs being based on Euclidian distances of candidate vectors from said channel response, wherein said means for determining LLRs includes:

means for determining a Euclidian distance between said initial candidate vector and said channel response,
means for determining a reduced basis matrix corresponding to a reduced basis description of the lattice wherein said reduced basis matrix comprises substantially orthogonal basis vectors,
means for determining column norms for said basis vectors and
means for determining distances for further determined candidate vectors, said means for determining distances being operable to determine each distance as a sum of
said calculated distance for said initial candidate symbol vector,
a product of a selected one of the predetermined column norms
and an integer multiple of the minimum inter-candidate distance, and
either a positive or a negative multiple of 2 of a scalar product of
said selected predetermined column with a vector difference between the channel response vector and the initial candidate vector..

**10.** Apparatus in accordance with claim 9 including symbol validation means for mapping said list of candidate transmitted symbol vectors to permitted transmitted symbol vectors.

**11.** Apparatus in accordance with claim 9 or claim 10 wherein said soft information determining means is operable to determine the probability of said symbol vector having been transmitted and then to determine the probabilities of all possible symbols having been transmitted from each of said transmitter antennas.

**12.** A MIMO wireless communications apparatus including a detector comprising apparatus in accordance with any one of claims 9 to 11.

**13.** A computer program product comprising computer executable instructions which, when executed on general purpose computer controlled communications apparatus, cause the apparatus to become configured to perform the method of any of claims 1 to 8.

**14.** A storage medium storing computer executable instructions which, when executed on general purpose computer controlled communications apparatus, cause the apparatus to become configured to perform the method of any of claims 1 to 10.

**15.** A signal carrying computer receivable information, the information defining computer executable instructions which, when executed on general purpose computer controlled communications apparatus, cause the apparatus to become configured to perform the method of any of claims 1 to 10 .

EP 1 912 371 A2

Fig. 1

Fig. 2

11

Fig. 3

Fig. 4

**BEGIN**

S1-2 — INITIALISE CANDIDATE VECTOR LIST WITH QUANTISED ESTIMATE OF TRANSMITTED LATTICE POINT IN THE REDUCED BASIS

S1-4 — PERTURB INITIAL VECTOR TO CREATE FURTHER CANDIDATE VECTORS

S1-6 — CONVERT EACH CANDIDATE VECTOR TO A TRANSMITTED SYMBOL VECTOR ESTIMATE

FOR EACH ELEMENT OF EACH TRANSMITTED SYMBOL VECTOR ESTIMATE

S1-8 — IS SYMBOL VALID?

NO → S1-10 — MAP TO NEAREST VALID SYMBOL

YES

S1-12 — CALCULATE PROBABILITY OF EACH CANDIDATE SYMBOL VECTOR HAVING BEEN TRANSMITTED

S1-14 — CALCULATE PROBABILITIES OF SYMBOLS HAVING BEEN TRANSMITTED FROM SPECIFIC ANTENNAS

S1-16 — DETERMINE LOG-LIKELIHOOD RATIOS FOR TRANSMITTED BITS

**END**

Fig. 5

## Fig. 6

BEGIN

S2-2 — CALCULATE EUCLIDEAN DISTANCE OF INITIAL SYMBOL VECTOR

S2-4 — DETERMINE MODIFIED CHANNEL STATE MATRIX AND ASSOCIATED VALUES

S2-6 — CALCULATE EUCLIDEAN DISTANCES OF FURTHER SYMBOL VECTORS

END

4x4, 16qam

Coded BER

SNR, dB

—□— MMSE
---△--- RL-MMSE (hard)
—○— RL-MMSE (soft)
—*— Sphere

## Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6724843 B

### Non-patent literature cited in the description

- **H. YAO ; G.W. WOMELL.** Lattice-Reduction-Aided Detectors for MIMO Communication Systems. *Proc. IEEE Globecom,* November 2002, 424-428
- **C. WINDPASSINGER ; R. FISCHER.** Low-Complexity Near-Maximum-Likelihood Detection and Precoding for MIMO Systems using Lattice Reduction. *Proc. IEEE Information Theory Workshop,* March 2003, 346-348
- **I. BERENGUER ; J. ADEANE ; I. WASSELL ; X. WANG.** Lattice-Reduction-Aided Receivers for MIMO-OFDM in Spatial Multiplexing Systems. *Proc. Int. Symp. on Personal Indoor and Mobile Radio Communications,* September 2004, 1517-1521
- **D. WUBBEN ; R. BOHNKE ; V. KUHN ; K. KAMMEYER.** MMSE-Based Lattice-Reduction for Near-ML Detection of MIMO Systems. *Proc. ITG Workshop on Smart Antennas,* 2004

- **A. LENSTRA ; H. LENSTRA ; L. LOVASZ.** Factoring Polynomials with Rational Coefficients. *Math Ann,* 1982, vol. 261, 515-534
- **L. LOVASZ.** An Algorithmic Theory of Numbers, Graphs and Convexity. *SIAM,* 1980
- **C. WINDPASSINGER ; L. LAMPE ; R. FISCHER.** From Lattice-Reduction-Aided Detection Towards Maximum-Likelihood Detection in MIMO Systems. *Proc. Int. Conf. on Wireless and Optical Communications,* July 2003
- **K. HIGUCHI ; H. KAWAI ; N. MAEDA ; M. SAWAHASHI.** Adaptive Selection of Surviving Symbol Replica Candidates Based on Maximum Reliability in QRM-MLD for OFCDM MIMO Multiplexing. *Proc. IEEE Globecom,* December 2004